(19) **Europäisches Patentamt**

**European Patent Office**

**Office européen des brevets**

(11) Veröffentlichungsnummer: **0 095 579**
**B1**

(12) # EUROPÄISCHE PATENTSCHRIFT

(45) Veröffentlichungstag der Patentschrift:
**17.09.86**

(21) Anmeldenummer: **83103882.3**

(22) Anmeldetag: **20.04.83**

(51) Int. Cl.⁴: **H 03 K 17/08**

(54) Schutzschaltung für einen Schalttransistor.

(30) Priorität: **05.05.82 DE 3216833**

(43) Veröffentlichungstag der Anmeldung:
**07.12.83 Patentblatt 83/49**

(45) Bekanntmachung des Hinweises auf die Patenterteilung:
**17.09.86 Patentblatt 86/38**

(84) Benannte Vertragsstaaten:
**AT BE CH DE FR GB IT LI SE**

(56) Entgegenhaltungen:
**DE - A - 2 453 933**
**DE - A - 2 539 938**
**DE - A - 2 555 509**
**FR - A - 1 453 559**

**IBM TECHNICAL DISCLOSURE BULLETIN, Band 18, Nr. 10, März 1976, Seiten 3236-3237, New York, USA, S.D. MALAVIYA: "Self-protected totem pole driver"**

(73) Patentinhaber: **Siemens Aktiengesellschaft Berlin und München, Wittelsbacherplatz 2, D-8000 München 2 (DE)**

(72) Erfinder: **Brajder, Antonio, Dipl.-Ing., Am Europakanal 4, D-8520 Erlangen (DE)**

# Beschreibung

Die Erfindung bezieht sich auf eine Schutzschaltung für einen Schalttransistor mit einer Abschalteinrichtung für Ansteuerimpulse des Schalttransistors in der die Basis-Emitter-Spannung des Schalttransistors mit einer Referenzspannung eines vergleichenden Mittels vergleichbar ist.

Es ist eine Schutzschaltung für einen Schalttransistor mit einer Abschalteinrichtung für Ansteuerimpulse des Schalttransistors bekannt, wobei die Abschalteinrichtung von einem Komparator angesteuert wird, der eine Spannung am Schalttransistor mit einer Referenzspannung vergleicht und die Ansteuerimpulse bei Überlastung des Schalttransistors ausschaltet. Eine derartige Schutzschaltung ist aus der Zeitschrift «Elektronik» 1980, Heft 25, Seiten 46, 47 bekannt. Mit einer derartigen Schutzschaltung wird der Schalttransistor auf Entsättigung überwacht, d.h. es wird überprüft, ob eine Kollektor-Emitter-Spannung den bei gesättigtem Transistor auftretenden Wert übersteigt. Damit kann der Schalttransistor gegen Kurzschluss und Überlast geschützt werden. Bei der bekannten Schaltung wird also die an der Kollektor-Emitter-Strecke des Schalttransistors anstehende Spannung in einem Komparator mit einer dem Sättigungswert entsprechenden Referenzspannung verglichen und die Ansteuerimpulse werden abgeschaltet, wenn die Kollektor-Emitter-Spannung des Schalttransistors den Sättigungswert überschreitet.

Bei dieser Schaltung tritt jedoch folgendes Problem auf: Die Kollektor-Emitter-Spannung fällt beim Einschalten des Schalttranssistors relativ langsam ab und erreicht den niedrigen statischen Wert erst nach einer gewissen Verzögerungszeit. Um zu verhindern, dass während dieser Verzögerungszeit die Schutzschaltung anspricht, muss diese eine entsprechende Verzögerung aufweisen. Da diese Verzögerung auch beim Schalten auf einen vorhandenen Kurzschluss wirksam ist, kann sich der Kurzschlussstrom in der Verzögerungszeit ungehindert aufbauen. Wenn der Schalttransistor mit hohem Basisstrom betrieben wird oder wenn es sich dabei um eine Darlington-Stufe mit hoher Verstärkung handelt, erreicht der Kurzschlussstrom oft Werte, die zumindest nur für eine begrenzte Anzahl von Kurzschlussvorgängen während der Betriebsdauer des Schalttransistors zulässig sind.

Eine Schutzschaltung für Schalttransistoren der eingangs genannten Art ist aus der Zeitschrift «IBM Technical Disclosure Bulletin», Band 18, Nr. 10, Seiten 3236–3237 bekannt. In dieser Schutzschaltung wird die Basis-Emitter-Spannung des Schalttransistors mit einer Referenzspannung eines vergleichenden Mittels verglichen. Als vergleichendes Mittel ist eine Schottky-Diode vorgesehen, deren Anode mit der Basis des Schalttransistors und deren Kathode mit dem Kollektor des Transistors verbunden sind. Beim Ansteigen der Basis-Emitter-Spannung des Schalttransistors wird die Schottky-Diode leitend und führt den überschüssigen Basisstrom des Schalttransistors über einen Transistor und einen Widerstand zum Ausgang.

Ferner ist aus der DE-OS 2 555 509 eine Schaltungsanordnung mit einem kurzschlussfesten Ausgang bekannt, wobei eine die Strombegrenzungsstufe des Ausgangstransistors bildende Diodenschaltung elektrisch parallel zu der Reihenschaltung der Basis-Emitter-Strecke des Ausgangstransistors und seines Emitterwiderstandes geschaltet ist. Die Diodenschaltung umfasst eine Zenerdiode und die Emitter-Basis-Strecke eines Transistors. Dieser Transistor steuert einen monostabilen Multivibrator. Sobald ein Kurzschluss in der Last auftritt, steigt der über die Emitter-Kollektor-Strecke des Ausgangstransistors fliessende Strom und der Spannungsabfall der Emitter-Basis-Strecke des Ausgangstransistors an. Beim Überschreiten des durch die Zenerdiode eingestellten Schwellspannungswertes wird die Diodenschaltung leitend, der monostabile Multivibrator wird in seinem quasistabilen Zustand gesteuert und der Ausgangstransistor wird in seinen Sperrzustand geschaltet. Die Diodenschaltung bleibt solange leitend, bis der monostabile Multivibrator in seinen stabilen Zustand zurückkippt.

Mit diesen beiden letztgenannten Schaltungsanordnungen kann man nur den Strom jeweils des Ausgangstransistors im Falle eines Kurzschlusses begrenzen. Ausserdem sprechen die Schutzschaltungen jeweils bedingt durch das vergleichende Mittel erst nach einer Ansprechverzögerung an.

Aufgabe der Erfindung ist es daher, eine Schutzschaltung der eingangs genannten Art ohne Ansprechverzögerung auszubilden.

Diese Aufgabe wird erfindungsgemäss dadurch gelöst, dass als vergleichendes Mittel ein Komparator vorgesehen ist, dass zur Speicherung des Ausgangssignals des Komparators ein speicherndes Mittel vorhanden ist, das dieses Ausgangssignal der Abschalteinrichtung zuführt.

Da als vergleichendes Mittel ein Komparator vorgesehen ist, anstatt einer Schottky-Diode oder einer Zener-Diode, reagiert die erfindungsgemässe Schutzschaltung sofort auf kleinste Spannungsunterschiede an der Basis des Schalttransistors in bezug auf eine Referenzspannung. Die Schottky-Diode in der Schutzschaltung der eingangs genannten Art wird funktionsmässig als Schwellwertgeber verwendet und hat somit gegenüber einem Komparator eine Ansprechverzögerung. Ausserdem ist dem Ausgang des Komparators ein speicherndes Mittel zugeordnet. Dieses speichernde Mittel steuert die Abschalteinrichtung, indem das Ausgangssignal des vergleichenden Mittels gespeichert und der Abschaltvorrichtung zugeführt wird. Dadurch wird erreicht, dass die Ansteuerimpulse für eine vorbestimmte Zeit von der Basis des Schalttransistors ferngehalten werden. Somit erhält man eine Schutzschaltung für einen Schalttransistor, die gegenüber der Schutzschaltung der eingangs genannten Art ohne Ansprechverzögerung anspricht und den Schalttransistor abschaltet.

In einer Ausführungsform ist als speicherndes Mittel ein Speicher vorgesehen, der einen taktflanken-gesteuerten Rücksetzeingang hat und dessen Ausgang mit einem Sperreingang der Abschalteinrichtung verbunden ist. Zur Rücksetzung dieses Speichers können die Ansteuerimpulse dem taktflanken-gesteuerten Rücksetzeingang des Speichers zugeführt sein. Damit wird die Abschaltung mit dem Verschwinden des einen Kurzschlussstrom hervorrufenden Ansteuerimpulses oder mit dem Auftreten eines neuen Ansteuerimpulses wieder aufgehoben.

Anstatt der Abschalteinrichtung einen gesonderten Speicher vorzuschalten, kann auch der Komparator zur Erzielung einer Speicherwirkung zwischen seinem Ausgang und seinem Eingang eine Rückkopplungsdiode aufweisen. Wenn der Komparator einmal angesprochen hat, bleibt er also bis zum Rücksetzen im angesprochenen Zustand.

Die Rücksetzung des Komparators mit Speicherwirkung kann dadurch erfolgen, dass die Ansteuerimpulse über eine Diode und einen von einem Widerstand überbrückten Kondensator einem Eingang des Komparators zugeführt sind, so dass eine Flanke der Ansteuerimpulse den Komparator zurücksetzt.

Bei einer älteren Anmeldung von uns ist bei der Schutzschaltung die Kollektor-Emitter-Strecke des Schalttransistors mit der Reihenschaltung einer Diode und eines Kondensators überbrückt, wobei die Ansteuerimpulse über einen Widerstand dem Verbindungspunkt von Diode und Kondensator zugeführt sind und wobei der Verbindungspunkt von Diode und Kondensator mit einem Vergleichseingang des Komparators verbunden ist. Bei dieser Schutzschaltung können der Verbindungspunkt und die Basis des Schalttransistors über Entkopplungsdioden zusätzlich mit demselben Vergleichseingang des Komparators verbunden sein. Somit wird bei dieser Schutzschaltung also sowohl die Basis-Emitter-Spannung als auch die Kollektor-Emitter-Spannung des Schalttransistors überwacht. Wenn man nur die Basis-Emitter-Spannung überwacht, wird zwar ein Kurzschluss erkannt, jedoch nicht jeder Überlastfall. Eine Überlastung des Schalttransistors kann nämlich nicht nur durch einen Stromanstieg im Lastkreis, sondern z.B. auch durch einen von einem zu geringen Basisstrom hervorgerufenen Spannungsanstieg an der Kollektor-Emitter-Strecke des Schalttransistors verursacht werden. Wenn man die Überwachung der Basis-Emitter-Spannung mit der Überwachung der Kollektor-Emitter-Spannung kombiniert, so erreicht man mit der Basisspannungsüberwachung einen sehr schnellen Schutz im Kurzschlussfall und mit der Emitter-Kollektor-Spannungsüberwachung einen sicheren Schutz für nahezu alle denkbaren Überlastfälle.

Zwischen Ausgang und einem mit der Referenzspannung beaufschlagten Vergleichseingang des Komparators kann ein Rückkopplungskondensator angeordnet sein. Bei einem derartig beschalteten Komparator bleibt ein Abschaltbefehl für eine bestimmte Mindestzeit gespeichert. Nach Ablauf dieser Mindestzeit kann beispielsweise eine zusätzliche Kollektor-Emitter-Spannungsüberwachung den Schalttransistor endgültig ausschalten.

Zur weiteren Erläuterung der Erfindung wird auf die Zeichnung Bezug genommen, in der ein Ausführungsbeispiel einer Schutzschaltung für einen Schalttransistor nach der Erfindung schematisch veranschaulicht ist.

Fig. 1 zeigt eine erfindungsgemässe Schutzschaltung, in den

Fig. 2 und 3 ist die Funktion der Schutzschaltung nach Fig. 1 veranschaulicht und die Fig. 4 und 5 zeigen weitere Ausführungsformen.

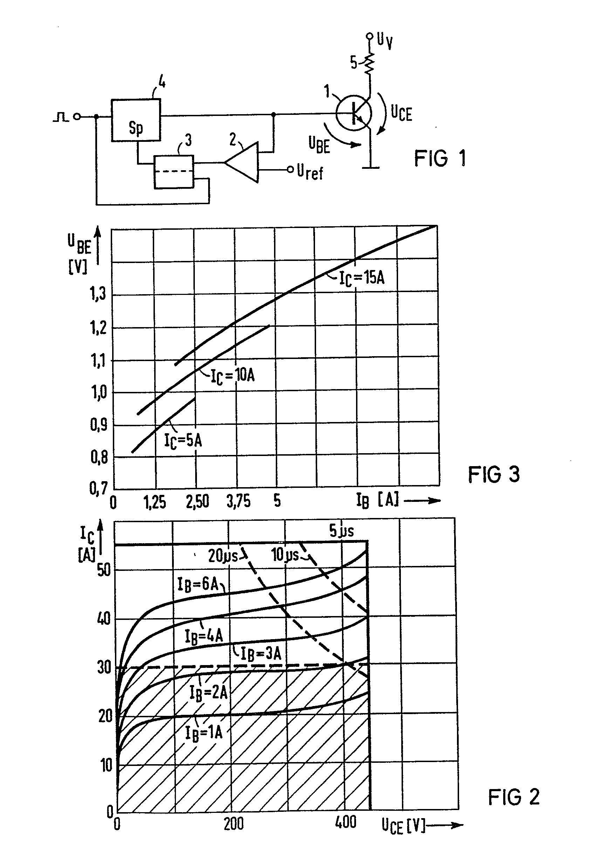

Fig. 1 zeigt das schematisierte Grundschaltbild der erfindungsgemässen Schutzschaltung. Eine Last 5 ist in Serie mit einem Schalttransistor 1 an eine Versorgungsspannungsquelle $U_v$ angeschlossen. Wenn die Last 5 kurzgeschlossen wird oder einen zu kleinen Widerstand aufweist, so könnte dies zu einem unzulässig hohen Strom durch den Schalttransistor 1 und damit zu dessen Zerstörung führen. Um dies zu verhindern, ist die erfindungsgemässe Schutzschaltung vorgesehen. Diese im folgenden beschriebene Schutzschaltung lässt sich ebenso einsetzen, wenn anstelle des Schalttransistors 1 eine Darlington-Transistoranordnung verwendet wird.

Der Basis des Transistors 1 werden Ansteuerimpulse über eine symbolisch dargestellte Abschalteinrichtung 4 zugeführt, mit der Einschaltimpulse für den Schalttransistor 1 im Störungsfall unterbrochen bzw. kurzgeschlossen werden können. Diese Abschalteinrichtung wird von einem Komparator 2 angesteuert, der die Basis-Emitter-Spannung $U_{BE}$ mit einer Referenzspannung $U_{ref}$ vergleicht. Dem Komparator ist ein Speicher 3 nachgeschaltet, der ein vom Ausgang des Komparators 2 abgegebenes Abschaltsignal abspeichert. Der Ausgang des Speichers 3 ist mit einem Sperreingang Sp der Abschalteinrichtung 4 verbunden. Im Ausführungsbeispiel nach Fig. 1 sind die Ansteuerimpulse für den Schalttransistor 1 einem Rücksetzeingang des Speichers 3 zugeführt.

Die Funktion dieser Anordnung wird nachfolgend anhand der Diagramme nach Fig. 2 und Fig. 3 näher erläutert. Fig. 2 zeigt die Abhängigkeit des Kollektorstroms $I_C$ von der Kollektor-Emitter-Spannung $U_{CE}$ mit dem Basisstrom $I_B$ als Parameter. Dabei ist der mit einem Kästchen umrandete, für Wertepaare $I_C$, $U_{CE}$ zulässige Bereich dargestellt. Innerhalb des zulässigen Bereichs ist wiederum der schraffierte Bereich, der periodisch ausgenutzt werden darf, und der nicht schraffierte Bereich, der nur für eine begrenzte Zahl N, z.B. N < 3000 von Vorgängen erreicht werden darf, zu unterscheiden. Ferner sind Bereiche für verschiedene zulässige Einschaltdauern, z.B.

20 bzw. 10 µs abgegrenzt. Aufgabe einer Schutzschaltung ist es, dafür zu sorgen, dass der Transistor 1 den erlaubten Betriebsbereich, und zwar möglichst den schraffierten Betriebsbereich, nicht verlässt. Wenn also bei eingeschaltetem Schalttransistor 1 z.B. durch einen Kurzschluss der Last 5 der Kollektorstrom $I_C$ ansteigt, so muss der Schalttransistor 1 ausgeschaltet werden, bevor der Kollektorstrom $I_C$ den der betreffenden Kollektor-Emitter-Spannung $U_{CE}$ und dem eingestellten Basisstrom $I_B$ zugeordneten maximalen Kollektorstrom $I_C$ überschreitet.

Als Kriterium für einen derartigen Störungsfall wird bei der erfindungsgemässen Schutzschaltung der Anstieg der Basis-Emitter-Spannung $U_{BE}$ herangezogen. Wie ein typisches $I_B/U_{BE}$-Diagramm nach Fig. 3 nämlich zeigt, steigt bei konstantem Basisstrom $I_B$ mit zunehmendem Kollektorstrom $I_C$ auch die Basis-Emitter-Spannung $U_{BE}$ an. Dieser Anstieg ist zwar nicht proportional zum Anstieg des Kollektorstroms $I_C$, aber doch signifikant genug, um zumindest einen Kurzschlussfall zu erkennen.

Man wird also bei der Schaltung nach Fig. 1 die Referenzspannung $U_{ref}$ so wählen, dass bei einem fest eingestellten Basisstrom $I_B$ die Basis-Emitter-Spannung $U_{BE}$ stets unterhalb der Referenzspannung $U_{ref}$ bleibt, jedoch im Kurzschlussfall diese Referenzspannung $U_{ref}$ überschreitet und damit über die Abschalteinrichtung 4 zum Verschwinden eines am Schalttransistor 1 anstehenden Einschaltimpulses führt. Da die Basis-Emitter-Strecke einen aufgeprägten Basisstrom nahezu unverzögert leitet, also nahezu kein dynamischer Überschwinger der Basis-Emitter-Spannung $U_{BE}$ beim Einschalten des Basisstroms $I_B$ auftritt, kann die Abschaltung im allgemeinen unverzögert erfolgen. Eine eventuell erforderliche kleine Verzögerung könnte mit einem in Fig. 1 nicht dargestellten RC-Glied mit kleiner Zeitkonstante erfolgen. Da die Basis-Emitter-Spannung $U_{BE}$ dem Kollektorstrom $I_C$ praktisch unverzögert folgt, erhält man also im Kurzschlussfall eine sehr schnelle Abschaltung des Schalttransistors 1, so dass auch bei sehr hohen Anstiegsgeschwindigkeiten des Kurzschlussstroms der schraffierte, für periodische Vorgänge erlaubte Betriebsbereich des Schalttransistors nicht überschritten wird.

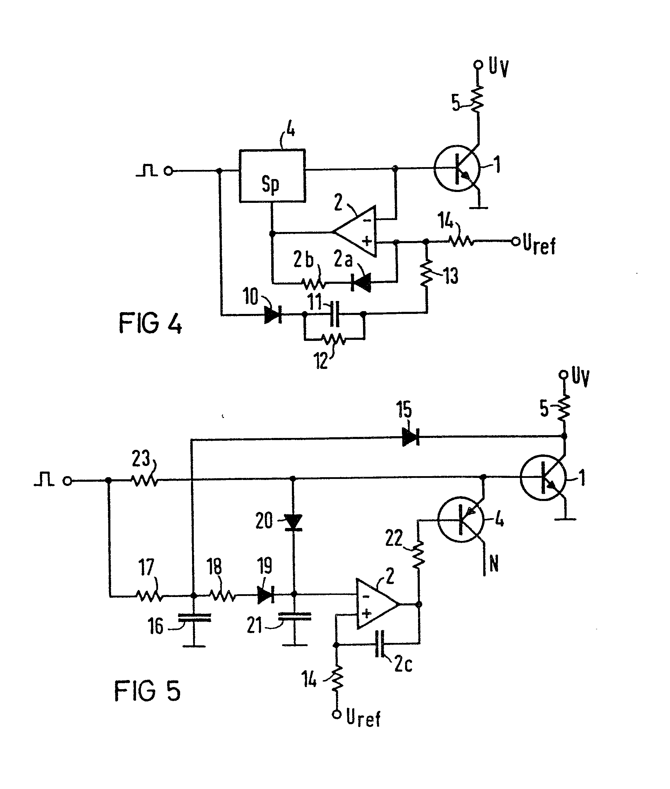

Ein weiteres Ausführungsbeispiel ist in Fig. 4 dargestellt. Dieses Ausführungsbeispiel entspricht im wesentlichen der Schaltung nach Fig. 1, wobei jedoch kein gesonderter Speicher 3 vorgesehen ist, sondern der Komparator 2 selbst eine Speicherfunktion aufweist. Dies wird erreicht, indem man zwischen den Plus-Eingang und den Ausgang des Komparators 2 die Reihenschaltung einer Diode 2a und eines Widerstands 2b schaltet. Am Minus-Eingang des Komparators 2 steht die Basis-Emitter-Spannung des Schalttransistors 1 und am Plus-Eingang des Komparators 2 über einen Widerstand 14 die Referenzspannung $U_{ref}$ an. Solange die Basis-Emitter-Spannung $U_{BE}$ unter der Referenzspannung $U_{ref}$ liegt, ist die Ausgangsspannung des Komparators 2 positiv und der Rückkopplungszweig durch die Diode 2a abgeblockt. Wird aber die Basis-Emitter-Spannung des Schalttransistors grösser als die Referenzspannung $U_{ref}$, so wird die Ausgangsspannung des Komparators 2 negativ und führt über die Abschalteinrichtung 4 zu einer Abschaltung eines anstehenden Einschaltimpulses. Ausserdem wird die negative Spannung über den Widerstand 2b und die in diesem Fall in Leitrichtung liegende Diode 2a auf den positiven Eingang des Komparators 2 zurückgekoppelt, so dass die negative Ausgangsspannung des Komparators 2 auch dann noch erhalten bleibt, wenn die Basis-Emitter-Spannung des Schalttransistors 1 nach Ansprechen der Abschalteinrichtung auf Null geht. Um den mit dem Komparator 2 realisierten Speicher wieder zurückzusetzen, werden seinem Plus-Eingang über die Reihenschaltung einer Diode 10, eines von einem Widerstand 12 überbrückten Kondensators 11 und eines Widerstands 13 ausserdem die Ansteuerimpulse zugeführt. Wenn der Kurzschluss beseitigt ist, d.h. am Minus-Eingang des Komparators 2 keine Spannung mehr ansteht, so wird mit der nächsten positiven Flanke eines Ansteuerimpulses über die genannte Reihenschaltung ein positiver Impuls auf den wegen der Rückkopplung mit dem Widerstand 2b und der Diode 2a noch negativen Plus-Eingang des Komparators 2 übertragen. Dieser Eingang wird daher kurzzeitig positiv, so dass die Selbsthaltung aufgehoben und das Sperrsignal für die Abschalteinrichtung beseitigt wird.

Ein weiteres Ausführungsbeispiel der Erfindung ist schliesslich in Fig. 5 dargestellt. Dabei ist der Basis-Emitter-Strecke des Schalttransistors 1 die Reihenschaltung einer Diode 20 und eines Kondensators 21 parallel geschaltet. Der Verbindungspunkt von Diode 20 und Kondensator 21 ist mit dem Minus-Eingang des Komparators 2 verbunden. Der Ausgang des Komparators 2 ist über einen Widerstand 22 mit der Basis eines als Abschalteinrichtung dienenden Abschalttransistors 4 verbunden, dessen Kollektor-Emitter-Strecke parallel zur Kollektor-Emitter-Strecke des Schalttransistors 1 liegt. Dem Plus-Eingang des Komparators 2 ist die Referenzspannung $U_{ref}$ über einen Widerstand 14 zugeführt. In einem Rückkopplungszweig zwischen dem Ausgang des Komparators 2 und dessen Plus-Eingang ist ein Kondensator 2c eingefügt. Soweit bisher beschrieben wirkt die Schaltung nach Fig. 5 wie die Schaltung nach Fig. 1, wobei mit dem Kondensator 21 eine kleine Ansprechverzögerung für die Abschalteinrichtung realisiert ist. Mit dem Rückkopplungskondensator 2c wird für eine Zeit, die durch die Zeitkonstante des aus dem Rückkopplungskondensator 2c und dem Widerstand 14 bestehenden RC-Glieds bestimmt ist, eine Selbsthaltung des Komparators 2 erzielt. Damit erhält man also bei Ansprechen der Schutzeinrichtung eine Mindestabschaltzeit, die z.B. bei 5 bis 10 Mikrosekunden liegen kann.

Da mit der Überwachung der Basis-Emitter-Spannung des Schalttransistors 1, wie bereits erläutert, im wesentlichen nur Kurzschlüsse erfasst werden können, ist in der Schutzschaltung nach Fig. 5 eine zweite, auf den Anstieg der Kollektor-Emitter-Spannung ansprechende Abschaltvorrichtung vorgesehen. Dazu liegt zwischen Kollektor und Emitter des Schalttransistors 1 die Reihenschaltung einer Diode 15 und eines Kondensators 16, wobei die Kathode der Diode 15 mit dem Kollektor des Schalttransistors 1 verbunden ist. Dem Verbindungspunkt der Diode 15 und des Kondensators 16 werden über einen Widerstand 17 die Ansteuerimpulse zugeführt. Ausserdem ist dieser Verbindungspunkt über einen Widerstand 18 und eine Diode 19 mit dem Minus-Eingang des Komparators 2 verbunden.

Wenn bei dieser Schaltungsanordnung ein Einschaltimpuls auftritt, so wird über den Widerstand 17 der Kondensator 16 aufgeladen. Im störungsfreien Betrieb erreicht die Spannung am Kondensator 16 jedoch keinen Wert, der ausreichend wäre, den Komparator 2 anzusteuern. Nach einer gewissen Verzögerungszeit nach Auftreten des Einschaltimpulses wird nämlich der Schalttransistor 1 leitend und der Kondensator 16 über die Diode und den Schalttransistor 1 auf die Kollektor-Emitter-Spannung des Schalttransistors 1 entladen. Um sicherzustellen, dass ein Einschaltimpuls im störungsfreien Betrieb nicht zu einem Ansprechen des Komparators 2 führt, muss also die Zeitkonstante des mit dem Widerstand 17 und dem Kondensator 16 gegebenen RC-Glieds lang sein gegenüber der Einschaltzeit des Schalttransistors 1. Wenn nun durch einen Störfall, beispielsweise durch einen zu geringen Basisstrom für den Schalttransistor 1, die Kollektor-Emitter-Spannung des Schalttransistors 1 ansteigt, so wird der Kondensator 16 über den Widerstand 17 auf eine entsprechende Spannung aufgeladen, bis schliesslich über den Widerstand 18 und die Entkopplungsdiode 19 der Komparator 2 angesteuert wird und durch den Abschalttransistor 4 den Schalttransistor 1 abschaltet. Diese Abschaltung wird jedoch durch das für den Einschaltvorgang notwendige RC-Glied mit dem Kondensator 16 und dem Widerstand 17 ebenfalls verzögert. Da beim Abschalten des Schalttransistors 1 die Kollektor-Emitter-Spannung weiter ansteigt und zunächst noch ein Einschaltimpuls am Widerstand 17 ansteht, bleibt der Kondensator 16 auf eine hohe Spannung aufgeladen. Damit bleibt der Schalttransistor 1 solange ausgeschaltet, bis der Einschaltimpuls verschwindet und der Kondensator 16 über den Widerstand 17 entladen ist. Diese Schaltungsanordnung besitzt daher, was die beschriebene Kollektor-Emitter-Spannungsüberwachung betrifft, ein Selbsthalteverhalten, das durch Verschwinden des Einschaltimpulses wieder aufgelöst wird.

Bei der beschriebenen Schaltungsanordnung wird also der Schalttransistor 1 im Kurzschlussfall sehr schnell durch die Basis-Emitter-Spannungsüberwachung ausgeschaltet. Die mit dem Kondensator 2c festgelegte Mindestabschaltzeit ist so dimensioniert, dass nach ihrem Ablauf der Komparator 2 durch die Kollektor-Emitter-Spannungsüberwachung über den Kondensator 16 angesteuert bleibt, bis ein anstehender Einschaltimpuls wieder verschwunden ist.

Im Überlastfall, der mit der Basis-Emitter-Spannungsüberwachung nicht sicher erfasst werden kann, erfolgt die Abschaltung des Schalttransistors 1 direkt durch die Kollektor-Emitter-Spannungsüberwachung. Eine derartige Abschaltung erfolgt zwar im Gegensatz zum Kurzschlussfall erst nach einer gewissen Zeitverzögerung, da aber die zu berücksichtigenden Ströme geringer sind als im Kurzschlussfall, ist die Zeitverzögerung hier weniger kritisch. Wenn der Überlastfall erst während der Einschaltphase auftritt, so ist der Kondensator 16 bereits vorgeladen, so dass die Ansprechzeit wesentlich kürzer ist.

**Patentansprüche**

1. Schutzschaltung für einen Schalttransistor mit einer Abschalteinrichtung für Ansteuerimpulse des Schalttransistors in der die Basis-Emitter-Spannung des Schalttransistors mit einer Referenzspannung eines vergleichenden Mittels vergleichbar ist, dadurch gekennzeichnet, dass als vergleichendes Mittel ein Komparator (2) vorgesehen ist, dass zur Speicherung des Ausgangssignals des Komparators (2) ein speicherndes Mittel vorhanden ist, das dieses Ausgangssignal der Abschalteinrichtung (4) zuführt.

2. Schutzschaltung nach Anspruch 1, dadurch gekennzeichnet, dass die Ansteuerimpulse dem speichernden Mittel zur Erzielung einer Rücksetzung zugeführt sind.

3. Schutzschaltung nach Anspruch 1, dadurch gekennzeichnet, dass als speicherndes Mittel ein Speicher (3) vorgesehen ist.

4. Schutzschaltung nach Anspruch 1, dadurch gekennzeichnet, dass der Komparator (2) zur Erzielung einer Speicherwirkung zwischen seinem Ausgang und seinem nichtinvertierenden Eingang eine Rückkopplungsdiode (2a) aufweist.

5. Schutzschaltung nach Anspruch 1, dadurch gekennzeichnet, dass der Komparator (2) zur Erzielung einer Speicherwirkung zwischen seinem Ausgang und seinem nichtinvertierendem Eingang einen Kondensator (2c) aufweist.

6. Schutzschaltung nach Anspruch 2 und 4, dadurch gekennzeichnet, dass die Ansteuerimpulse über eine Diode (10) und einen von einem Widerstand (12) überbrückten Kondensator (11) dem nichtinvertierenden Eingang des Komparators (2) zugeführt sind.

7. Schutzschaltung nach Anspruch 1, dadurch gekennzeichnet, dass die Kollektor-Emitter-Strecke des Schalttransistors (1) mit einer Reihenschaltung einer Diode (15) und eines Kondensators (16) überbrückt ist, wobei die Ansteuerimpulse über einen Widerstand (17) den Verbindungspunkt von Diode (15) und Kondensator (16) zugeführt sind und wobei der Verbindungspunkt von Diode (15) und Kondensator (16) mit einem invertierenden Eingang des Komparators (2) verbunden ist und dass der Verbindungspunkt und die Basis des Schalttransistors (1) über Entkopplungsdioden (19, 20) mit dem invertierenden Eingang des Komparators (2) verbunden sind.

8. Schutzschaltung nach Anspruch 7, dadurch gekennzeichnet, dass der Basis-Emitter-Strecke des Schalttransistors (1) die Reihenschaltung der Entkopplungsdiode (20) und eines Kondensators (21) parallelgeschaltet ist.

## Claims

1. Protective circuit for a switching transistor, with a switching-off device for trigger pulses of the switching transistor, in which the base-emitter-voltage of the switching transistor can be compared with a reference voltage of a comparing means, characterised in that as comparing means there is provided a comparator (2), and in that for storage of the output signal of the comparator (2) there is a storage means which feeds this output signal to the switching-off device (4).

2. Protective circuit according to claim 1, characterised in that the trigger pulses are fed to the storage means to produce resetting.

3. Protective circuit according to claim 1, characterised in that as storage means there is provided a store (3).

4. Protective circuit according to claim 1, characterised in that the comparator (2) has a feedback diode (2a) between its output and its non-inverting input for producing a storage effect.

5. Protective circuit according to claim 1, characterised in that the comparator (2) has a capacitor (2c) between its output and its non-inverting input for producing a storage effect.

6. Protective circuit according to claims 2 and 4, characterised in that the trigger pulses are fed to the non-inverting input of the comparator (2) by means of a diode (10) and a capacitor (11) which is bridged by a resistance (12).

7. Protective circuit according to claim 1, characterised in that the collector-emitter-path of the switching transistor (1) is bridged by a series-connection of a diode (15) and a capacitor (16), wherein the trigger pulses are fed to the connecting point of diode (15) and capacitor (16) via a resistance (17), and wherein the connecting point of diode (15) and capacitor (16) is connected to an inverting input of the comparator (2), and in that the connecting point and the base of the switching transistor (1) are connected to the inverting input of the comparator (2) via decoupling diodes (19, 20).

8. Protective circuit according to claim 7, characterised in that the series-connection of the decoupling diode (20) and of a capacitor (21) is connected in parallel with the base-emitter-path of the switching transistor (1).

## Revendications

1. Circuit de protection pour un transistor de commutation avec un dispositif de débranchement pour des impulsions d'attaque du transistor de commutation, dans lequel la tension base-émetteur du transistor de commutation est susceptible d'être comparée à une tension de référence d'un moyen de comparaison, caractérisé par le fait que l'on prévoit, en tant que moyen de comparaison, un comparateur (2), que pour la mémorisation du signal de sortie du comparateur (2) est prévu un moyen de mémorisation qui applique ce signal de sortie au circuit de débranchement (4).

2. Circuit de protection selon la revendication 1, caractérisé par le fait que les impulsions d'attaque sont appliquées au moyen de mémorisation en vue d'obtenir une remise à l'état initial.

3. Circuit de protection selon la revendication 1, caractérisé par le fait que l'on prévoit, comme moyen de mémorisation, une mémoire (3).

4. Circuit de protection selon la revendication 1, caractérisé par le fait que le comparateur (2) comporte, pour l'obtention d'un effet de mémorisation entre sa sortie et son entrée non inverseuse, une diode de rétroaction (2a).

5. Circuit de protection selon la revendication 1, caractérisé par le fait que le comparateur (2) comporte, pour l'obtention d'un effet de mémorisation, entre sa sortie et son entrée non inverseuse, un condensateur (2c).

6. Circuit de protection selon les revendications 2 et 4, caractérisé par le fait que les impulsions d'attaque sont appliquées à l'entrée non inverseuse du comparateur (2), par l'intermédiaire d'une diode (10) et d'un condensateur (11) shunté par une résistance (12).

7. Circuit de protection selon la revendication 1, caractérisé par le fait que le circuit collecteur-émetteur du transistor de commutation (1) est shunté par un circuit série constitué par une diode (15) et par un condensateur (16), les impulsions d'attaque étant appliquées par l'intermédiaire d'une résistance (17) au point de liaison entre la diode (15) et le condensateur (16), alors que le point de liaison entre la diode (15) et le condensateur (16) est relié à une entrée inverseuse du comparateur (2), et que le point de liaison et la base du transistor de commutation (1) sont reliés, par l'intermédiaire de diodes de découplage (19, 20), à l'entrée inverseuse du comparateur (2).

8. Circuit de protection selon la revendication 7, caractérisé par le fait qu'en parallèle sur le circuit base-émetteur du transistor de commutation (1), est monté un circuit série constitué par la diode de découplage (20) et par un condensateur (21).

FIG 1

FIG 3

FIG 2

FIG 4

FIG 5